# EUROPEAN PATENT APPLICATION

(11) **EP 4 739 077 A1**
(43) Date of publication of application: **06.05.2026**
(21) Application number: 25211967.2
(22) Date of filing: 29.10.2025
(51) Int. Cl.: H10W 72/00, H10W 72/30

(54) **A METHOD OF MANUFACTURING A SEMICONDUCTOR DEVICE AND CORRESPONDING SEMICONDUCTOR DEVICE AND A SEMICONDUCTOR PACKAGE**

(30) Priority: 29.10.2024 NL 2038945
(71) Applicant: Nexperia B.V., 6534 AB Nijmegen (NL)
(72) Inventor: Poelma, Regnerus Hermannus, Nijmegen (NL); Shi, Ziliang, Shanghai (CN); Högerl, Jürgen, Hamburg (DE)
(74) Representative: Pjanovic, Ilija

(57) **Abstract**

In the first aspect of the present disclosure, there is provided a method of manufacturing a semiconductor device (100), comprising the steps of:
- providing a substrate (110);
- mounting a semiconductor die (120) having a first die surface and a second die surface opposite to the first die surface, with its first die surface to the substrate;
- mounting a spacer (140) having a first spacer surface and a second spacer surface opposite to the first spacer surface, with its first spacer surface on the second die surface;
- fusing bonding means (150) to the second spacer surface by means of ultrasonic fusing.

## Description

### Technical Field

The present disclosure relates to methods of manufacturing a semiconductor device and a corresponding semiconductor device as well as a semiconductor package.

### Background

Clip-bonding is a technique that is used in the semiconductor industry to provide electrical connection to semiconductor dies. In this method, a metal clip is soldered onto the semiconductor die, providing a robust and efficient connection compared to wire-bonding. This approach improves the current-carrying capacity, as the metal clip offers a thicker and more reliable electrical path than the thin wires used in wire-bonding. Additionally, clip-bonding enhances thermal dissipation by utilizing the clip's larger surface area to transfer heat more effectively from the die to the heat sink, which is essential in high-power applications where managing heat is crucial for device reliability.

To realize the connection between the metal clip and the semiconductor die, soldering is used to provide a mechanical and electrical bond between the clip and the die. During the process, both the metal clip and the die are heated to the solder's melting point, allowing the solder to flow and create a durable bond upon cooling.

Solder materials that are typically used comprise lead. Lead-based solders often have a high melting point, because of their fatigue resistance and long-term reliability. Furthermore, lead provides good wetting, this may ensure a strong and uniform bond. Other advantages include the ductility of the element and the high electrical conductivity.

However, lead is in recent times regarded more and more as an unwanted element due to its toxicity to human health. Products containing lead may end up in unwanted contact with humans which may be detrimental to their overall well-being and health. Furthermore, it can contaminate soil and water it contacts.

### Summary

It is thus the goal of the disclosure to achieve a semiconductor device which omits the use of lead. As the use of lead regarding the soldering process, it would be advantageous to provide a method of manufacturing such a semiconductor device without using lead.

In the first aspect of the present disclosure, there is provided a method of manufacturing a semiconductor device, comprising the steps of:
- providing a substrate;
- mounting a semiconductor die having a first die surface and a second die surface opposite to the first die surface, with its first die surface to the substrate;
- mounting a spacer having a first spacer surface and a second spacer surface opposite to the first spacer surface, with its first spacer surface on the second die surface;
- fusing bonding means to the second spacer surface by means of ultrasonic fusing.

It has been found that bonding means, such as bond clips, can be effectively connected to a spacer on a semiconductor die using ultrasonic, US, soldering or US welding, preferably US welding. This is a fusing process in which highfrequency ultrasonic vibrations are applied to two parts of the device under pressure and sometimes at elevated temperatures. The ultrasonic vibrations cause localized friction and heat at the interface of the materials. This frictional heat is sufficient to soften or melt the materials, leading to a solid-state bond, also known as fusion, without the need for external heating or melting of the entire material. This way the interface between the spacer and the bonding means are no longer present and no barrier longer exists for the current to pass. Furthermore, with this method a strong and electrically conductive connection can be made without the need of using any solder and is therefore the ultimate lead-free method.

One drawback of US soldering or US welding is that the vibrations can be detrimental for the semiconductor die. They could lead to breakage or chipping, making the semiconductor unusable. It has been found that including a spacer in this process results in a dampening of the vibrations on the semiconductor die. This principle is known as the Saint Vernant's principle, wherein localized high stress is redistributed in the surrounding material. Thus when a spacer is used the concentrated stress from the fusing process on one side results in a redistributed and thus diminishes stress on the other side, such that that material on one side can be fused, while the other is not harmed. Not only vibrations are to be shielded, but the spacer also provides a shield for the heat resulting from the US soldering or US welding process. By employing the spacer, the heat is dissipated throughout the spacer, ensuring no harmful effects result at the semiconductor from the US soldering or US welding process.

An additional benefit that is achieved by mounting a spacer onto the semiconductor die prior to fusing the bonding means there onto, is that a simpler design may be employed for the bonding means and that the constraints for a positioning device for positioning the bonding means can be relaxed. Namely, positioning a relatively heavy (heavier than a bond wire) and large bond clip with sub-micrometer-precision puts high demands on a positioning device. Namely, it needs to be accurate and fast enough to have the desirable yield and be commercially useful. Slight mispositioning might lead to chipping or cracking of the semiconductor die, for instance because its side edges, or passivation layers, or the bus bar are hit. When a spacer is already mounted on the semiconductor die, the bonding means can roughly be positioned correctly, since the possibility of breaking or cracking is no longer present. Furthermore, positioning a relatively light (lighter than bonding means) and smaller (than bonding means) spacer can be done more precisely with more ease. This would make the entire manufacturing process much more reliable, having higher yield, and having higher throughput.

Throughout this disclosure, we speak of US soldering and US welding being the same technique. The expert in the field would understand that a fusing method is meant, wherein no additional material is used, such that two materials are directly fused together to form a connection. This way, there is no to little interface experienced by current flowing from the one part to the other.

In an example of the disclosure, the mounting of the spacer to the semiconductor die is performed by diffusion soldering.

It has been found that the spacer should be mounted onto the semiconductor die using diffusion soldering or soldering in general. As previously discussed US soldering or US welding may not be employed, because of chances of breaking the semiconductor die. Therefore, the spacer is mounted on the semiconductor die using diffusion soldering. Diffusion soldering allows for strong connections between the semiconductor die and the spacer and allows the connection to be more robust against thermal expansion. Furthermore, it can be more environmentally friendly, because less solder is used and no flux is needed. Lastly, the connections that is made also has a reduced interface, since the solder would at least be partially diffused into the spacer, such that current might flow more easily and no solder splash out or fillet is present, nor will flux cleaning be required.

In an example of the disclosure, the method comprises a further step before the step of mounting the spacer to the semiconductor die, wherein the further step comprises providing a connection layer onto the first spacer surface.

The connection layer is utilized in the connection process of mounting the spacer onto the semiconductor die. In the field, the connection layer may also be known as a thin preform solder layer. By providing a connection layer onto the spacer prior to mounting the spacer onto the semiconductor die, it is ensured that the right amount of solder is present for the soldering process. Furthermore, it is assured that the material is present in the correct location. For instance, in prior art processes a thin solder layer is first provided on the semiconductor die. Since there typically is some error in the positioning of the spacer, more than necessary solder is applied semiconductor die. In prior art semiconductor manufacturing methods, this thus lead the use of additional solder, which is actually not needed/wasted (excess solder is typically a source of early device failure or shorts causing yield loss). Furthermore, providing such a thin solder layer on the semiconductor die, would be very difficult with melting processes, wherein the surface tension would cause the solder to ball-up, therefore also leading to the excessive use of solder to just cover enough of the intended mounting area for the spacer. These problems are all circumvented by providing a connection layer onto the spacer surface before mounting it to the semiconductor die.

In an example of the disclosure, providing a connection layer is performed by stamping the spacer with its first spacer surface onto a metal film.

Stamping a spacer onto a metal film may cause the metal film to adhere to the spacer and thus in other words to be picked-up by it. Due to Van der Waals forces, a metal film can be effectively connected to the spacer. It may be required to provide a thin flux coating on the metal film to increase the adhesive forces between the metal film and the spacer to improve their adherence. Herein, the effectiveness of the stamping process may depend on the thickness of the metal film. A too thick metal film may not be picked up, while a too thin metal film may not be effective as a connection layer. Furthermore, since the spacer and connection layer will be subjected to diffusion soldering, it does not matter that the connection is by Van der Waals forces or other types of adhesion forces (electrostatic, capillary, van der Waals or friction based).

Furthermore, it should be noted that when a thin metal layer is to be provided by thermal processes surface tension of the connection layer in liquid form is of importance. Typically, the wettability is not great causing any liquid process to result in very thick coating of a connection layer. It has been found that by stamping a very precise and uniform layer thickness can be achieved of the connection layer.

Lastly, It has been found that by using the stamping process to provide a connection layer to the spacer, predetermined patterns may even also be applied to the metal film, which would then we transferred to the spacer as well. Such patterns could be beneficial when the spacer is mounted to two semiconductor dies, or in case a gate terminal, or a bus bar separating the source, is provided on the second die surface, which should not be electrically or mechanically connected to the spacer.

In a second aspect of the disclosure, there is provided a semiconductor device comprising:
a substrate;
a semiconductor die having a first die surface and a second die surface opposite to the first die surface, wherein the first die surface is mounted on the substrate;
a spacer having a first spacer surface and a second spacer surface opposite to the first spacer surface, with its first spacer surface mounted to the semiconductor die;
bonding means directly fused to the second spacer surface.

It should be noted that elements discussed relating to the previous aspect of the disclosure also apply to the second and third aspect of the disclosure.

According to this second aspect a semiconductor device can be provided that is lead-free, since bonding means directly fused to the spacer, requiring no solder. This can be performed effectively by using ultrasonic, US, soldering or US welding, preferably US welding. The ultrasonic vibrations cause localized friction and heat at the interface of the materials. This frictional heat is sufficient to soften or melt the materials, leading to a solid-state bond, also known as fusion, without the need for external heating or melting of the entire material.

Providing a semiconductor device which is lead-free solves the contamination issue and the compliance to RoHS and ELV requirements.

Moreover, providing a semiconductor device, wherein the bonding means are directly fused to the second spacer surface solves the issue of failures caused by solder fatigue. This results in longer lifetimes of the final product, since a fused/bonded connection, preferably using US welding of metal to metal is more reliable than a thick solder joint.

In an example, the spacer may be mounted with its first spacer surface mounted to the semiconductor die by means of diffusion bonding process wherein a thin metal layer is provided. This has the advantage of being more reliable than thick lead containing solder joints that suffer from fatigue, contamination, flux residues, large fillet, solder spread and radiation issues.

The semiconductor device according to the disclosure has the additional advantage that the interface between the spacer and the bonding means are no longer present and thus no barrier exists for the current to pass, realizing less resistance from the current to flow.

The spacer is required, because the vibrations of US welding or US soldering could damage the semiconductor die. However, a spacer provides adequate dampening of the vibrations on the semiconductor die during the fusing process.

An additional benefit of the semiconductor device according to this second aspect of the disclosure is that a simpler design for the bonding means may be employed, thereby reducing the costs of the semiconductor device. Without a spacer the positioning of a relatively heavy (heavier than a bond wire) bond clip with nanometer-precision put high demands on a positioning device. Slight mispositioning might lead to chipping or cracking the semiconductor die, for instance because the side edges of the semiconductor die are hit. When a spacer is already mounted on the semiconductor die, the possibility of breaking or cracking by the bonding means is no longer present during the mounting thereof.

In an example of the disclosure a thickness of the spacer is at least 100 µm, more preferably at least 200 µm, most preferably at least 300 µm.

As mentioned before, the spacer is included to provide a dampening buffer direct fusing methods of the bonding means to the spacer, such as US welding or US soldering, preferably US welding. The above-mentioned thickness depend on the materials used of the spacer and the bonding means, which in turn dictate the power and intensity needed during the fusing methods of the bond means to the spacer. These thicknesses have been chosen to provide a damping and distancing for the delicate semiconductor die from the fusing process based on Saint Vernant's principle.

In an example of the disclosure, a material of the spacer is a metallic material comprising any of copper, a copper alloy, molybdenum, aluminum, or molybdenum alloy, preferably being copper.

The above-mentioned material are all perfect electrical conductors. Namely, the spacer not only provides a buffer/shield for the US welding process, but after mounting and fusing also provide an electrical connection from the semiconductor die to the bonding means. Furthermore, the above-mentioned materials have high thermal conductivities, helping to ensure that the produced heat produced from the US welding process or the operation of the semiconductor die is conducted away.

In an example of the disclosure the first spacer surface is smaller than the second die surface.

The inventors have found that by using a spacer with a smaller surface area than the semiconductor die, it can be assured that the edges of the semiconductor die are not touched during the mounting/alignment process of the spacer on the semiconductor die. The expert in the field understands that the edges of the semiconductor die are the most fragile part and that the greatest chance is present when means need to be connected to a semiconductor die, that chipping or breakage at the edges of the semiconductor die occur. Preferably the surface area of the first spacer surface is less than half, more preferably less than a quarter, most preferably less than an eight of the second die surface.

In a further example of the semiconductor device, the spacer comprises a connection layer provided on its first spacer surface.

Having a spacer with a pre-mounted connection layer provided on its first spacer surface ensures that the connection layer has a uniform thickness. Furthermore, during any soldering process, there is no further need of adding soldering material to the semiconductor device. Specifically, during diffusion soldering, the connection layer may penetrate into the spacer, such that a continuous seamless transition between the two is achieved. This results in a lower resistivity, since there is no interface for current to experience.

In an example thereof, the connection layer is made of a lead-free metallic material selected from a list not limiting: Tin Bismuth (Sn-Bi), Tin-Silver (Sn-Ag), Tin-Gold (Sn-Au), Tin-Indium (Sn-In), Tin-Antimony (Sn-Sb), Tin-Palladium (Sn-Pd), and Tin-Zinc (Sn-Zn).

As discussed in the background, lead is being banned from many application, because of the chances of contaminating the environment or of getting into contact with humans, creating a health hazard. Therefore, the above-mentioned list, which are all Tin-(Sn)-based alloys have been found to be good alternatives, which have a low melting point, high mechanical bonding strength, and a good wettability. More specifically, these alloys have been found that they can be beneficially employed for diffusion soldering.

In an example of the disclosure, the connection layer is less than 100 µm, preferably less than 50 µm, more preferably less than 10 µm.

The inventors have found that a preferably thin connection layer, having an above-mentioned thickness, is beneficial for the disclosure, since the spacer usually is made or a material having a greater conductivity than the material of the connection layer. More importantly, the inventors have found that when the connection layer is thin enough a seamless transition can be achieved when the spacer with connection layer are diffusion soldered to the semiconductor die. When the connection layer is thin enough, most of said layer would penetrate into the spacer and metalize the die top (e.g. 2^{nd} die surface), while still offering a sturdy connection to the semiconductor die. For this to be effective, the uniformity of the connection layer is also of importance, such that a connection layer having a uniform layer thickness would be preferred.

In yet another example of the disclosure, the connection layer is only partially provided on the spacer, such that at least a part of the first spacer surface is exposed.

In some instances, it may be necessary to have at least part of the first spacer surface to be exposed, such that a gap of approximately the thickness of the connection layer is formed when the spacer with the connection layer is mounted onto the semiconductor die. This would for instance, allow to provide a connective terminal through this gap, such that the spacer is not in electrical contact with the terminal, but is in electrical contact with the semiconductor die. One could think of a gate trench provided in the connection layer, such that a gate terminal can be provided in electrical contact with the second die surface sandwiched between the semiconductor die and the spacer in non-electrical contact with either the spacer or the connection layer.

In an example of the disclosure, the bonding means are a bond clip.

A bond-clip is a metal clip used to electrically and mechanically connect a semiconductor die to external circuitry. Its benefits include improved current-carrying capacity, enhanced heat dissipation, reduced electrical resistance, and better durability compared to traditional wire-bonding methods. The bond clip has a slightly different configuration compared to traditional bond clips, since the bond clip is not intended to connect to the semiconductor die, but to the spacer. Therefore, it is expected that the bond clip is a flat portion parallel to the semiconductor die.

In a third aspect of the disclosure, there is provided a semiconductor package comprising the semiconductor device according to any of the preceding claims, wherein the semiconductor package further comprises:
a source, a drain and a gate terminal, each operatively connected to the semiconductor device;
an encapsulant at least substantially encapsulating the semiconductor package, wherein at least part of the source, drain and gate terminal are exposed to allow electrical connection to the semiconductor package.

A semiconductor package is to be used in specific applications, wherein the semiconductor package may be exposed to "harsh" environments. Therefore, the semiconductor device is protected with an encapsulant to provide electrical and mechanical insulation to external influences. For the semiconductor device to be still usable, a source, a drain and a gate terminal are operatively connected to the semiconductor device and at least part of the terminals is exposed.

The expert in the field may also know the connection layer as a preform layer.

All in all, the semiconductor device, the method of manufacturing one, and the semiconductor package comprising one, all provide lead-free alternatives, such that lead contamination may not occur upon human contact with elements of the semiconductor device. Furthermore, such a semiconductor device may no longer be able to contaminate soil and water with lead.

### Brief description of the figures

Fig. 1 depicts a method in accordance with the disclosure;
Fig. 2 depicts another method in accordance with the disclosure;
Fig. 3 depicts a semiconductor device according to the disclosure;
Fig. 4 depicts another semiconductor device according to the disclosure;
Fig. 5 shows a three-dimensional view of a semiconductor device according to the disclosure;

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected", "coupled", "mounted", or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

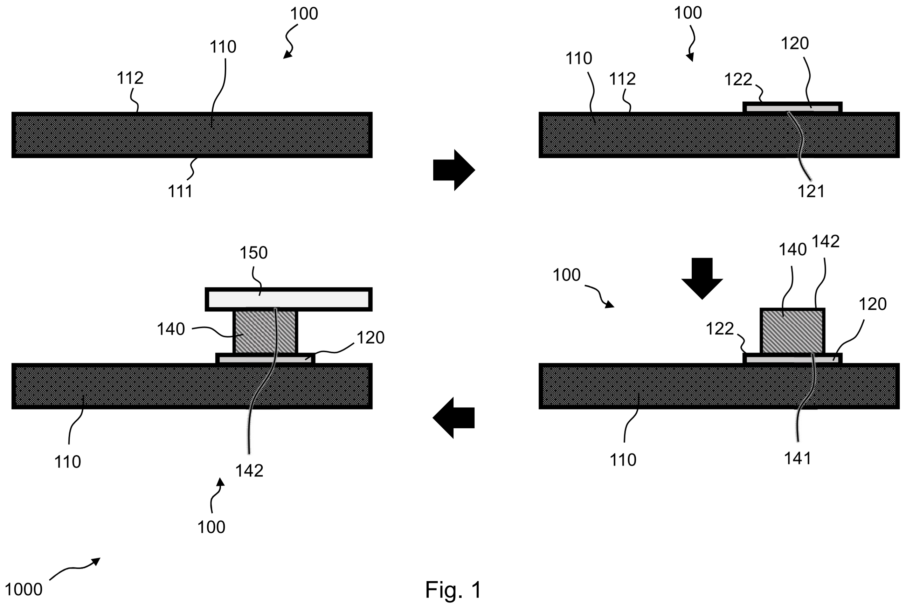

In Fig. 1, the method 1000 in accordance with the disclosure is shown. Herein, is first a substrate 110, having a first substrate surface 111 and a second substrate surface 112, is provided to manufacture a semiconductor device 100. Second, a semiconductor die 120, having a first die surface 121 and a second die surface 122, is provided. A semiconductor die can be mounted onto a substrate with different methods; a first mention-worthy method would be the "hot die attach". For this method a thin sinter layer provided on top of the substrate 110, which needs to be baked to ensure that the solvents are evaporated, such that they do not get trapped underneath the semiconductor die. Baking typically occurs at elevated temperatures, such as ~100 degrees Celsius. When is ensured that the solvents have been evaporated, the semiconductor die 120 can be attached. This is performed by actively pressing the semiconductor die into the sinter layer, the process may be done at room temperature (25 degrees Celsius, but may also be performed at elevated temperatures ~100 degrees Celsius to improve the bonding. Thereafter, the entire sandwich of substrate 110, sinter layer, and semiconductor die 120 is sintered at elevated temperatures ~250 degrees Celsius while pressing the semiconductor die 120 into the substrate. The pressures that are exerted may be in the order of a few mega Pascals.

In a second mention-worthy method, called "cold die attach", a semiconductor die 120 is bonded to a substrate 110 by utilizing a uniform solder ribbon layer. This layer is provided on the substrate 110, whereafter a semiconductor die 120 simply is placed upon the solder ribbon layer. Heat from subsequent manufacturing steps is then utilized to melt the solder ribbon layer to form the bond.

The next step in the method according to the disclosure is that a spacer 140 is mounted onto the semiconductor die 120. Since the first spacer surface 141 is smaller than the second die surface 122 a bonding method utilizing pressure would no longer work. Namely, this would pose the risk of breaking the semiconductor die 120 due to localized pressure there onto. Therefore, typically soldering methods are chosen without the need of applying pressure, for instance reflux soldering, or diffusion soldering, etc.

Thus far, a few methods have been discussed which utilize a solder material. In the method according to the disclosure care is taken that the solder material that is used does not contain lead. Particularly, beneficial materials have been found to comprise a Tin-(Sn)-alloy selected from a list not limiting: Tin Bismuth (Sn-Bi), Tin-Silver (Sn-Ag), Tin-Gold (Sn-Au), Tin-Indium (Sn-In), Tin-Antimony (Sn-Sb), Tin-Palladium (Sn-Pd), and Tin-Zinc (Sn-Zn).

Lastly, bonding means 150, for instance a bond clip, are fused to the second spacer surface 142 of the spacer 140. This fusing is performed by US welding, wherein the spacer 140 and the bonding means 150 are connected to each other without the need of additional solder material. The two materials are directly connected, whereby the interface between the two 140/150 is faded. This way, any current that would flow from or to the semiconductor die 120, would experience less resistivity going through the boding means 150 and the spacer 140 compared to when they would traditionally be soldering with a solder material. Furthermore, this would create the ultimate lead-free connection.

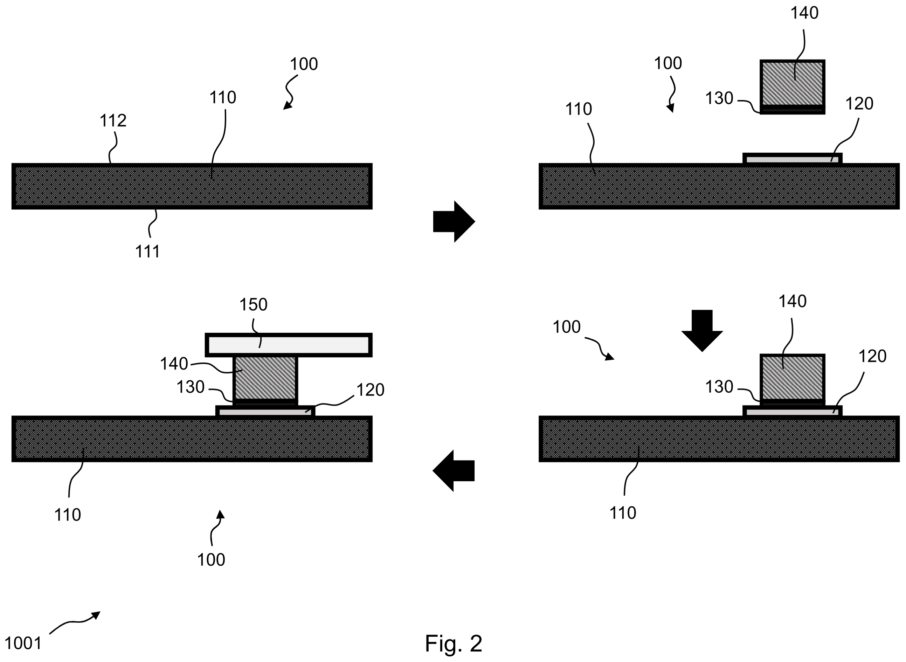

Fig. 2 another method 1001 according to the disclosure is shown, similar to the method 1000 as shown in Fig. 1. The method of Fig. 2, however, differs from the method depicted and explained in Fig.1. In Fig. 2, a connection layer 130 is added to the spacer 140. The connection layer 130 is added to the spacer in order to create strong and reliable joints in the soldering process. This results from the facilitating of atomic diffusion between the solder and the materials being joined. This layer also comprises a lead-free metallic, like gold, nickel, or silver, which form an intermediary layer between the solder and the underlying substrate or components.

The connection layer 130 is attached or mounted to the spacer 120 by means of stamping or sputtering or the like. Stamping herein refers to the pushing of the spacer 120 against a metal film, comprising the materials of the connection layer 130. This pushing may be sufficiently firm that the connection layer 130 attaches or sticks to the spacer 120. Sputtering may alternatively be performed, though this requires additional care of cleaning or shielding the sides of the spacer from the connection layer material. Alternatively, plating could be used to provide the connection layer 130 on top of the spacer 120, which may be performed as liquid chemical plating or vapor plating.

Further, the process is, as said, similar to the method of Fig. 1. Herein first the substrate 110 is provided in a first step of the method. After the substrate has been provided, a semiconductor die 120 may be attached to the substrate. In a separate step, the stamping of the connection layer 130 on the spacer 140 may be performed.

After this step has been performed, the spacer 140, now having the attached connection layer 130 may be provided on the semiconductor die 120. Since the first spacer surface 141 is smaller than the second die surface 122 a bonding method utilizing high pressure would no longer work. Namely, this would pose the risk of breaking the semiconductor die 120 due to localized pressure there onto. Therefore, typically soldering methods are chosen without the need of applying high pressure, for instance reflux soldering, or diffusion soldering, etc. Herein the connection layer is used as a diffusion solder layer, which is added to the spacer in order to create strong and reliable joints in the soldering process.

Finally, the bonding means are attached to the spacer using ultrasonic welding.

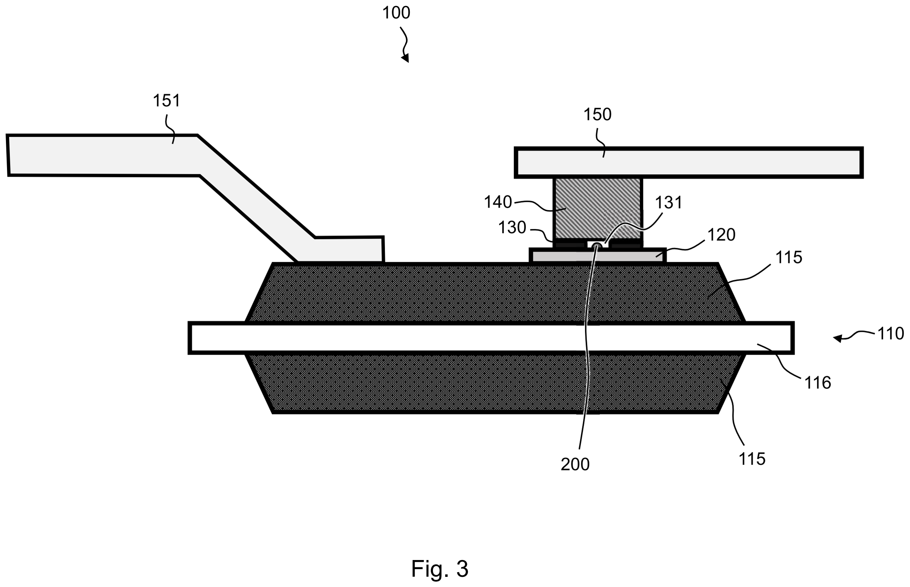

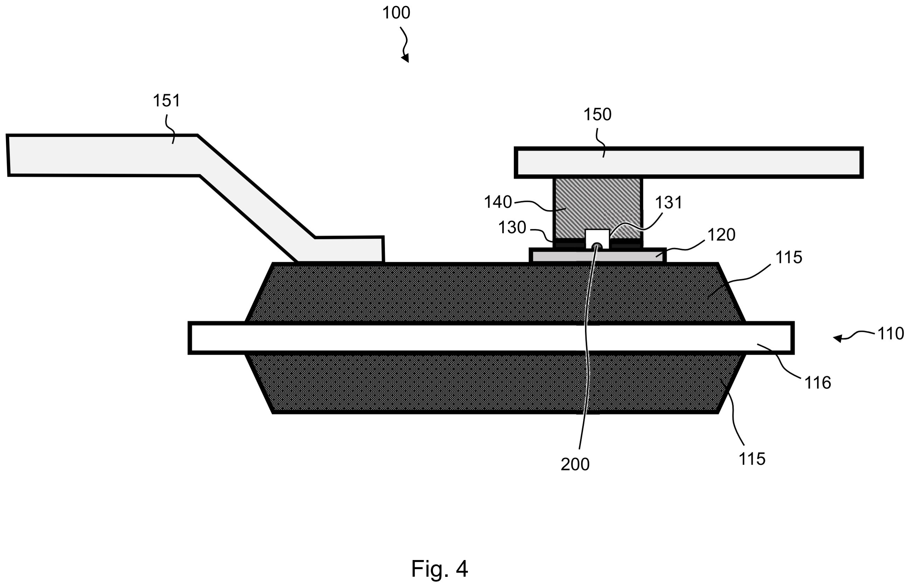

In Figs. 3 and 4, a side view of semiconductor package according to the disclosure is depicted. Figs. 3 and 4 shows a semiconductor package being manufactured in accordance with the disclosure. Herein a further bonding means 151 connected to the substrate 100 is depicted. This connection may likewise be performed by ultrasonic welding, or alternative connection methods being lead-free. In Figs. 3 and 4, the substrate 110 further comprises a metal-insulator-metal sandwich structure, wherein the conductive layer (metal) 115 may comprise copper or the like, and the insulation layer (insulator) 116 may be a ceramic, which may be aluminum oxide, Al₂O₃, or aluminum nitride, AIN, or the like.

Furthermore, a gate trench is shown 131, wherein a gate terminal 200 is provided only electrically connecting to the semiconductor die 120. The gate trench 131 is formed by providing a pattern on the connection layer 130 before stamping the spacer 140 into said connection layer 120. This way the uniform thickness and the pattern can be guaranteed.

It should be noted that in Fig. 3 the gate trench is only made by a pattern in the connection layer 130, whereas the gate trench in Fig. 4 is also formed due to a recess in the spacer 140. The benefit of the latter is that- when stamping is chosen to adhere the connection layer to the spacer 130, no special patterns need to be made in the connection layer 130, since the spacer would not "pick-up" the metal film, since there is no material of the spacer touching the metal film during stamping.

Semiconductor package further is manufactured according to the method of Fig.2. Herein the bonding means 150 are attached by ultrasonic welding to the spacer 140. Herein the spacer 140 is attached to the semiconductor die 120 while having a connection layer 130 attached to the spacer. This connection layer 130 may comprise a trench region, which does not contain the material of the connection layer. Therefore, the connection layer 130 may contain a pattern. The semiconductor die is attached to the sandwich structured substrate 110.

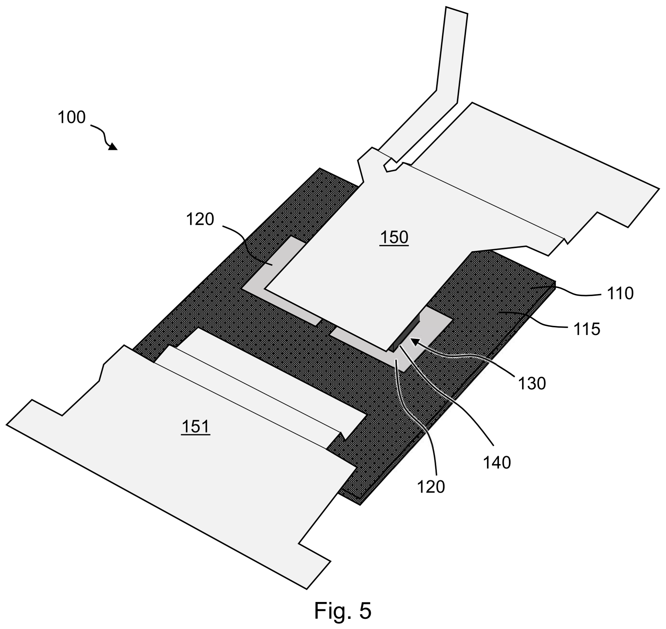

Fig. 5 shows a three-dimensional view of a semiconductor package according to the disclosure. Herein elements according to the previous pictures may be observed, First, is the presence of the further bonding means 151, explained in Fig. 3 and Fig. 4. These further bonding means are arranged to provide an electrical connection from the conductive layer 115 and the further semiconductor die 120 to external circuitry (not shown). The bonding means 150 and the further bonding means 151 could thus be considered as terminals of the semiconductor device 100, or, alternatively, they could be further connected to terminals of the semiconductor device 100. This may be an AC terminal or a DC terminal. The semiconductor die 120 is provided on the conductive layer 115. The semiconductor is connected to the spacer 140, wherein the spacer 140 has a connection layer 130 attached to it, which is positioned in between the spacer 140 and the semiconductor die 120. There may be multiple semiconductor dies 120 as may be observed in the figure. The bonding means are connected to the spacer(s). Each semiconductor die 120 may be connected to a separate spacer 140 or the spacer 140 may be one continuous element, which is connected to both semiconductor dies 120.

From Fig. 3 and Fig. 4, it is clear that the connection layer 130 may comprise a gate region, in which the connection layer is omitted. This may also be provided in the semiconductor package shown in Fig. 5, though this cannot be observed from this viewpoint. The bonding means 150 may be further connected to a terminal, which may be a DC terminal. The semiconductor package may further comprise other elements, such as signal pins, gate connection wires or the like, which are not shown here.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims.

### REFERENCE NUMBERS

- 100: semiconductor device
- 110: substrate
- 111: first substrate surface
- 112: second substrate surface
- 115: conductive layer of substrate
- 116: insulation layer of substrate
- 120: semiconductor die
- 121: first die surface
- 122: second die surface
- 130: connection layer
- 131: gate trench
- 140: spacer
- 141: first spacer surface
- 142: second spacer surface
- 150: bonding means
- 151: further bonding means
- 200: gate terminal
- 1000: method according to disclosure

## Claims

1. A method of manufacturing a semiconductor device, comprising the steps of:
- providing a substrate;
- mounting a semiconductor die having a first die surface and a second die surface opposite to the first die surface, with its first die surface to the substrate;
- mounting a spacer having a first spacer surface and a second spacer surface opposite to the first spacer surface, with its first spacer surface on the second die surface;
- fusing bonding means to the second spacer surface by means of ultrasonic fusing.

2. The method according to claim 1, wherein the mounting of the spacer to the semiconductor die is performed by diffusion soldering.

3. The method according to any of the preceding claims, wherein the method comprises a further step before the step of mounting the spacer to the semiconductor die, wherein the further step comprises providing a connection layer onto the first spacer surface.

4. The method according to claim 3, wherein providing a connection layer is performed by stamping the spacer with its first spacer surface onto a metal film.

5. A semiconductor device comprising:
a substrate;
a semiconductor die having a first die surface and a second die surface opposite to the first die surface, wherein the first die surface is mounted on the substrate;
a spacer having a first spacer surface and a second spacer surface opposite to the first spacer surface, with its first spacer surface mounted to the second die surface;
bonding means directly fused to the second spacer surface.

6. The semiconductor device according to claim 5, wherein a thickness of the spacer is at least 100 µm, more preferably at least 200 µm, most preferably at least 300 µm.

7. The semiconductor device according to any of the claims 5-6, wherein a material of the spacer is a metallic material comprising any of copper, a copper alloy, molybdenum, aluminum, or molybdenum alloy.

8. The semiconductor device according to any of the claims 5-7, wherein the first spacer surface is smaller than the second die surface.

9. The semiconductor device according to any of the claims 5-8, wherein the spacer comprises a connection layer provided on its first spacer surface.

10. The semiconductor device according to claim 9, wherein the connection layer is made of a lead-free metallic material selected from a list not limiting: Tin Bismuth (Sn-Bi), Tin-Silver (Sn-Ag), Tin-Gold (Sn-Au), Tin-Indium (Sn-In), Tin-Antimony (Sn-Sb), Tin-Palladium (Sn-Pd), and Tin-Zinc (Sn-Zn).

11. The semiconductor device according to any of the claims 9-10, wherein a thickness of the connection layer is less than 100 µm, preferably less than 50 µm, more preferably less than 10 µm.

12. The semiconductor device according to any of the claims 9-11, wherein the connection layer is only partially provided on the spacer, such that at least a part of the first spacer surface is exposed.

13. The semiconductor device according to any of the claims 5-11, wherein the bonding means are a bond clip.

14. A semiconductor package comprising the semiconductor device according to any of the preceding claims, wherein the semiconductor package further comprises:
a source, a drain and a gate terminal, each operatively connected to the semiconductor device;
an encapsulant at least substantially encapsulating the semiconductor package, wherein at least part of the source, drain and gate terminal are exposed to allow electrical connection to the semiconductor package.
